(19) **Europäisches Patentamt / European Patent Office / Office européen des brevets**

(11) **EP 1 594 173 B1**

(12) **EUROPEAN PATENT SPECIFICATION**

(45) Date of publication and mention
of the grant of the patent:
**02.12.2009 Bulletin 2009/49**

(21) Application number: **03768385.1**

(22) Date of filing: **26.12.2003**

(51) Int Cl.:
*H01L 35/32* (2006.01)     *H01L 35/16* (2006.01)

(86) International application number:
**PCT/JP2003/017080**

(87) International publication number:
**WO 2004/061982 (22.07.2004 Gazette 2004/30)**

(54) **COOLING DEVICE FOR ELECTRONIC COMPONENT USING THERMO-ELECTRIC CONVERSION MATERIAL**

KÜHLVORRICHTUNG FÜR ELEKTRONISCHES BAUELEMENT UNTER VERWENDUNG VON THERMOELEKTRISCHEM KONVERSIONSMATERIAL

DISPOSITIF DE REFROIDISSEMENT POUR COMPOSANT ELECTRONIQUE UTILISANT UN MATERIAU DE CONVERSION THERMOELECTRIQUE

(84) Designated Contracting States:
**FR**

(30) Priority: **27.12.2002 JP 2002379509**

(43) Date of publication of application:
**09.11.2005 Bulletin 2005/45**

(73) Proprietors:
- **National Institute for Materials Science
 Tsukuba-shi,
 Ibaraki 305-0047 (JP)**
- **Muroran Institute of Technology
 Muroran-shi
 Hokkaido 050-8585 (JP)**

(72) Inventors:
- **HIRAI, Shinji
 Muroran-shi, Hokkaido 050-0082 (JP)**
- **NISHIMURA, Toshiyuki
 Tsukuba-shi, Ibaraki 305-0032 (JP)**

- **UEMURA, Yoichiro
 Ushiku-shi, Ibaraki 300-1232 (JP)**
- **MORITA, Shigenori c/o Nitto Denko Corporation
 Ibaraki-shi, Osaka 567-0041 (JP)**
- **OHTA, Michihiro
 Muroran-shi, Hokkaido 050-0072 (JP)**
- **IGARASHI, Kazumasa
 c/o Nitto Denko Corporation
 Ibaraki-shi, Osaka 567-0041 (JP)**

(74) Representative: **Röthinger, Rainer
 Wuesthoff & Wuesthoff
 Patent- und Rechtsanwälte
 Schweigerstrasse 2
 81541 München (DE)**

(56) References cited:
 EP-A- 1 143 592     JP-A- 9 092 761
 JP-A- 2001 352 106     JP-A- 2002 118 297
 JP-A- 2002 353 521

## Description

Technical Field

The present invention relates to cooling devices for heat-generating electronic components such as semiconductor integrated circuit elements, and particularly to a cooling device using a thermoelectric conversion material.

Background Art

A CPU in a PC, for example, is equipped with an aluminum fin-shaped radiation plate to inhibit a rise in temperature of the CPU by heat generation or, in some cases, is forced to cool by supplying current to a Peltier element from an external power supply (for example, Patent Documents 1 and 2). In addition, some known devices provide a larger cooling effect using an electromotive force produced by the Seebeck effect of a thermoelectric conversion material (for example, Patent Documents 3 to 6).

Patent Document 1: Japanese Unexamined Patent Application Publication No. 9-139525

Patent Document 2: Japanese Unexamined Patent Application Publication No. 2002-50727

Patent Document 3: Japanese Examined Utility Model Registration Application Publication No. 7-15140

Patent Document 4: Japanese Unexamined Patent Application Publication No. 7-202094 (Japanese Patent No. 2710750)

Patent Document 5: Japanese Unexamined Patent Application Publication No. 2001-308395

Patent Document 6: Japanese Unexamined Patent Application Publication No. 2002-151873

Disclosure of Invention

A conventional method for efficiently dissipating heat from an electronic component requiring cooling is the attachment of a radiation plate that is fin-shaped to provide a larger area. Such a fin-shaped radiation plate alone, however, lacks the ability to dissipate heat effectively. On the other hand, among cooling systems using a thermoelectric conversion material is a $\pi$-type Peltier element including a combination of p-type and n-type thermoelectric conversion materials. This element is supplied with current to cool a component.

A conventional Peltier element requires a pair of p-type and n-type thermoelectric conversion materials arranged in series. This element has a complicated structure and involves high production cost because both p-type and n-type materials must be prepared and combined. In addition, this element requires external current supply, and thus involves operating cost.

In the known devices that provide a larger cooling effect using an electromotive force produced by a Seebeck effect, another thermoelectric conversion material is supplied with the electromotive force instead of external current to produce a Peltier effect. Alternatively, the electromotive force is used as a driving force for a fan motor or a piezoelectric vibrator. The need for combining such a component, however, complicates the structure of the devices.

According to Patent Documents 2 to 6, electric power generated from heat by a thermoelectric conversion element including both n-type and p-type materials is supplied to an external load such as an external charger, a fan, and a piezoelectric vibrator to aid cooling. It may be pointed out that the generation of electric power removes heat to result in a decrease in temperature. The connection of an external load (resistor), however, increases the overall resistance of the circuit, and thus decreases current flowing through the circuit. In addition, the use of an external load is insufficient because part of electric power consumed by the external load is inevitably converted to heat again. According to Patent Document 2, external power supply is required for cooling. According to Patent Documents 4 to 6, an electronic component such as a control circuit is required together with power supply therefor.

To solve the above problems based on a novel cooling principle, the present invention provides a cooling device that can replace a conventional cooling device for an electronic component or can be used in combination with a conventional cooling device.

Specifically, the present invention provides (1) a cooling device for an electronic component. This cooling device includes a thermoelectric conversion material disposed between two electrodes that function as a cathode and an anode and are electrically short-circuited. The cooling device is brought into contact with an electronic component requiring cooling so that one electrode side in contact with the thermoelectric conversion material becomes a low-temperature side and the other electrode side becomes a high-temperature side. A temperature difference between the two electrodes causes the thermoelectric conversion material to produce a thermoelectromotive force which generates current to cool the high-temperature side.

Also, provided is (2) the cooling device for an electronic component according to Item (1) above, wherein the thermoelectric conversion material is either a p-type material or an n-type material or a combination of p-type and n-type materials arranged alternately in series.

The present invention further provides (3) a cooling system including two or more stacked cooling devices according to Item (1) above.

The present invention further provides (4) a cooling system including the cooling device according to Item (1) above.

The cooling device according to the present invention may be attached to a part of an electronic component where its temperature rises. The temperature of one electrode side of the cooling device in contact with the component rises as the temperature of the component rises. On the other hand, the other electrode side in contact with the thermoelectric conversion material shows no significant temperature rise because the electrode side is exposed to a refrigerant such as outside air and water. Accordingly, a temperature difference occurs spontaneously between the two sides of the cooling device. This temperature difference allows current to flow through the cooling device and cool the high-temperature side in contact with the cooling device.

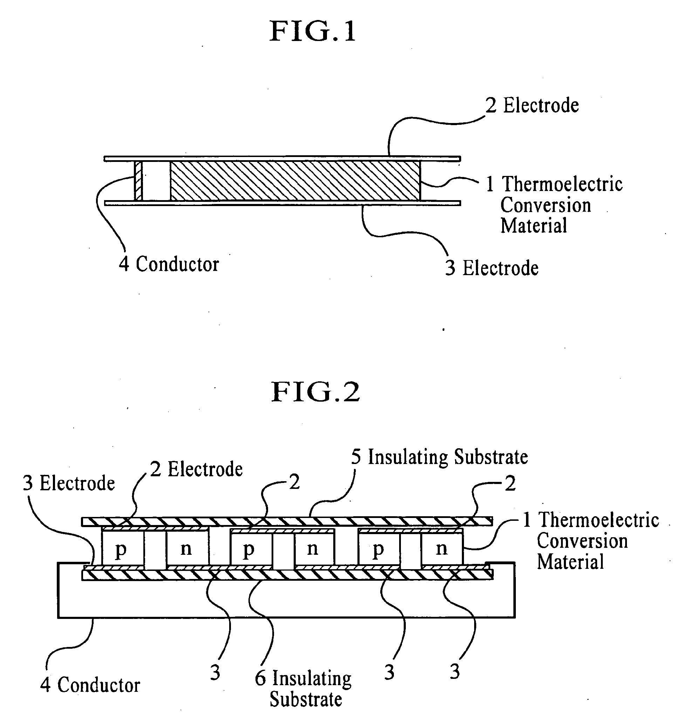

The heat dissipation effect of the cooling device according to the present invention will now be theoretically described according to an embodiment shown in Fig. 1. In this embodiment, a plate-like thermoelectric conversion material 1 is disposed between plate-like electrodes 2 and 3 that function as a cathode and an anode and are electrically short-circuited with, for example, a conductor 4. The thermoelectric conversion material 1 used may be any material that is either a p-type material or an n-type material or a combination of p-type and n-type materials arranged alternately in series. The surface of the bottom electrode 3 of the plate-like cooling device is brought into contact with a heat-generating device (not shown) requiring cooling, such as a semiconductor device.

In the drawing of the radiation plate, the temperature $T_H$ on the bottom side is raised by the heat-generating device requiring cooling. On the other hand, the temperature $T_L$ of the top electrode 2 of the radiation plate does not rise as high as the temperature $T_H$ on the bottom side if the surface of the electrode 2 is exposed to a refrigerant such as outside air and water. As a result, a temperature difference of $\Delta T = T_H - T_L$ occurs between the top and bottom electrodes 2 and 3 of the radiation plate.

It is known that the temperature difference between the top and bottom electrodes 2 and 3 of the thermoelectric conversion material 1 produces an electromotive force represented by the following formula:

$$V = \alpha \cdot \Delta T$$

wherein $\alpha$ is a Seebeck coefficient.

If the top and bottom electrodes 2 and 3 of the radiation plate are electrically short-circuited, current I represented by the following formula (1) flows through the thermoelectric conversion material 1 according to Ohm's law:

$$I = V/r = \alpha \cdot \Delta T / r \quad (1)$$

wherein r is the resistance of the thermoelectric conversion material 1.

If a p-type thermoelectric conversion material is used, current flows through the thermoelectric conversion material from the high-temperature side to the low-temperature side. If, on the other hand, an n-type material is used, current flows in the reverse direction, though the sign of the Seebeck coefficient is minus. In either case, therefore, the high-temperature side is cooled.

When current flows through the thermoelectric conversion material 1, a Peltier effect occurs at the junctions between the different conductors, namely the thermoelectric conversion material and the electrodes, to cool the bottom electrode 3 and heat the top electrode 2.

In addition, the overall thermoelectric conversion material 1 generates Joule heat due to its internal resistance. Accordingly, when current flows, the bottom electrode 3 side in contact with the heat-generating device requiring cooling generates heat represented by the following formula (2):

$$I^2 \cdot r/2 - \alpha \cdot I \cdot T_H \quad (2)$$

The formula (2) necessarily yields a negative value, as clarified by substituting the formula (1) into the formula (2) and modifying it. This means that heat is removed to cool the bottom electrode 3 side.

On the other hand, the temperature of the top electrode 2 side of the radiation plate rises by generation of heat represented by the following formula (3):

$$I^2 \cdot r/2 + \alpha \cdot I \cdot T_H \quad (3)$$

The above formulas show that a larger amount of current produces a larger cooling effect. Hence, the connection of an external load is disadvantageous in view of cooling a heat-generating device because the external load increases the overall resistance of the circuit. If the top and bottom electrodes 2 and 3 of the cooling device are connected to an external load, rather than are short-circuited, the external load consumes the resultant current to dissipate heat removed by the cooling device to the outside through the electrical circuit. In this case, however, the external load decreases the amount of current, and thus lowers the cooling effect.

Brief Description of the Drawings

Fig. 1 is a sectional view of a cooling device using either a p-type or n-type thermoelectric conversion material according to an embodiment of the present invention; and
Fig. 2 is a sectional view of a cooling device having a π-type structure including a combination of p-type and n-type thermoelectric conversion materials according to another embodiment of the present invention.

Best Mode for Carrying Out the Invention

Fig. 1 is a sectional view of a cooling device using either a p-type or n-type thermoelectric conversion material according to an embodiment of the present invention.

Actual electronic components often have a flat top surface, and the cooling device according to the present invention typically has a plate-like structure accordingly. Such a plate-like structure is hereinafter referred to as a "radiation plate" according to need. This cooling device includes a p-type or n-type plate-like thermoelectric conversion material 1 disposed between a plate-like top electrode 2 and a plate-like bottom electrode 3. The two electrodes 2 and 3 function as a cathode and an anode, and are electrically short-circuited with, for example, a conductor 4.

A larger contact area is more advantageous between an electronic component and the electrode side in contact with the electronic component. The contact area is therefore preferably increased by providing irregularities on the electronic component and fitting the surface profile of the electrode to the irregularities. Also, the contact area between the electrode side opposite the electronic component and a refrigerant is preferably increased by providing, for example, fins, irregularities, or heat pipes to efficiently dissipate heat and thus increase the temperature difference between the two electrode sides. Because a cooling effect appears at the junction between the thermoelectric conversion material and one electrode, the electrode requires the area corresponding to that of the electronic component to be cooled. Also, the opposite electrode is preferably connected over a larger area to reduce electrical resistance.

The thermoelectric conversion material used may be a sintered material or an ingot cut into a predetermined shape. The thermoelectric conversion material 1 may be any material that preferably has a high Seebeck coefficient, more preferably has a high power factor or figure of merit. The above formula (2) shows that the current I must be increased to enhance the cooling effect. According to the formula (1), the current I may be increased by increasing the Seebeck coefficient, decreasing the resistance of the thermoelectric conversion material 1, and increasing the temperature difference between the cathode and the anode, namely the two electrodes 2 and 3. While the Seebeck coefficient depends on the properties of the thermoelectric conversion material 1, the resistance depends on the size thereof. Accordingly, the resistance may be decreased by, for example, reducing the thickness of the thermoelectric conversion material 1 used.

The shapes of the thermoelectric conversion material and the electrodes are preferably fitted to that of the heat-generating device to be cooled, and they preferably have a larger contact area. The thermoelectric conversion material and the electrodes preferably have the largest possible contact area. The electrodes may also be made of flexible films, rather than solid plates. An insulating film or a ceramic plate, for example, may be provided on the outside of the electrodes. Alternatively, the electrodes may be substrates having electrodes (ceramics or insulating films having patterned electrodes).

Because the electrodes or the substrates having electrodes also function to transfer heat, they are preferably made of a material having excellent thermal and electrical conductivity. Examples of such a material include Cu, Al, Ni, Ag, and Pt. If Cu is used, Au plating or Ni/Au plating may be used to prevent, for example, oxidation. It is also effective to use different materials for the electrodes on the high-temperature side and the low-temperature side.

The electrodes and the thermoelectric conversion material may be bonded with solder or a brazing material. Alternatively, they may be bonded only by mechanical pressing if the pressing can provide an electrically low-resistance junction. An optimum solder or brazing material must be selected according to the materials used for the electrodes and the thermoelectric conversion material or the production process. The solder or brazing material used preferably provides a low-resistance junction and excellent long-term reliability. Alternatively, the electrodes may be formed directly on the thermoelectric conversion material by sputtering, vacuum deposition, or spraying, or the thermoelectric conversion material may be formed directly on the electrodes by, for example, doctor blading, a sol-gel process, sputtering, or deposition.

If the thermoelectric conversion material does not have high performance, the cooling device may include at least one or more p-type materials and at least one or more n-type materials that are arranged alternately in series, as shown in Fig. 2. A structure including equal numbers of p-type materials and n-type materials, namely a π-type structure, is the same as those of general thermoelectric conversion elements. Thermoelectric conversion materials 1 are disposed between plate-like top and bottom electrodes 2 and 3. The electrodes 3 at both ends are electrically short-circuited with, for example, a conductor 4. The electrodes 2 and 3 are formed on insulating substrates (ceramics or films) 5 and 6, respectively. In the π-type structure, in which the electrodes at both ends are short-circuited, the conductor 4 can be formed on the insulating substrate 6 together with the electrodes 3. The π-type structure can therefore be produced by a simpler process. In addition, this structure can reduce the number of junctions for wiring to decrease the electrical resistance of the circuit and increase connection reliability.

The cooling effect of a combination of p-type and n-type thermoelectric conversion materials arranged alternately in series is maximized under the same conditions as in the case of a p-type or n-type material alone, namely by increasing the Seebeck coefficient and decreasing the resistance (decreasing the resistivity and the thickness is effective). Also, the electrodes are made of a low-resistance material. In addition, the thermoelectric conversion materials and the electrodes are connected with a material (for example, solder or a brazing material) with low electrical resistance and high connection reliability. The solder or brazing material used is selected for each thermoelectric conversion material used because the metal during use may diffuse into the thermoelectric conversion material.

The radiation plate is preferably attached to a heat-generating device with, for example, a thermally conductive grease to achieve higher thermal conductivity, though the plate may also be formed directly on the heat-generating device.

Two or more radiation plates having the above structure may be stacked to form a cooling system. Because the properties of thermoelectric conversion materials generally depend on temperature, an optimum material may be selected for each temperature range to provide higher overall cooling efficiency than a single radiation plate is used for the overall temperature range. Specifically, a radiation plate including a material having higher thermoelectric properties at high temperatures is disposed near a heat-generating device requiring cooling while a radiation plate including a material having higher thermoelectric properties at low temperatures is disposed away from the heat-generating device requiring cooling.

In addition, a cooling system including a radiation plate having the above structure may be formed by attaching radiation fins or a cooling device such as a Peltier element to the radiation side of the radiation plate to increase the temperature difference and thus enhance the cooling efficiency.

Example 1

A radiation plate having the structure shown in Fig. 1 was produced by providing a BiTe-based p-type thermoelectric conversion material (4 mm long by 10 mm wide by 4 mm thick) between electrodes made of copper foil (40 $\mu$m thick) and soldering the surfaces of the thermoelectric conversion material and the copper foil.

A surface of the radiation plate was brought into contact with a surface of a planar heater, as a heat-generating device requiring cooling. A Peltier element was provided on the opposite surface of the radiation plate to cool the surface and increase the temperature difference between the high-temperature side and the low-temperature side.

While the Peltier element was supplied with current to cool the radiation plate, the heater was supplied with an AC voltage of 50 V. According to measurement with a chromel-alumel thermocouple, the temperature of the junction between the heater and the radiation plate was 62.5°C.

Comparative Example 1

A radiation plate having the same structure as in Fig. 1 was produced with its top and bottom electrodes not short-circuited, and was attached to a planar heater. The temperature measured under the same conditions as in Example 1 was 64.0°C.

These test results show that the temperature on one side, namely 64.0°C, could be reduced by about 1.5°C by changing the two electrodes, which functioned as a cathode and an anode, from an open-circuit state to a short-circuit state.

That is, the above results confirmed that the cooling device, namely the radiation plate, according to the present invention was short-circuited so that a temperature difference between the two sides of the device produced an electromotive force by a Seebeck effect to generate current which flowed through the thermoelectric conversion material to decrease the temperature on the high-temperature side by a Peltier effect.

Example 2

The BiTe-based p-type thermoelectric conversion material was replaced with a BiTe-based n-type thermoelectric conversion material. According to temperature measurement performed under the same conditions as in Example 1, the temperature in the case where the two electrodes, which functioned as a cathode and an anode, were changed from an open-circuit state to a short-circuit state was 66.5°C, and the temperature in the case where the electrodes were not short-circuited was 67.7°C. These results show a temperature drop of 1.2°C.

Example 3

As a radiation plate having the structure shown in Fig. 2, PV2-S, manufactured by Eco 21, Inc., was used with its terminals short-circuited. A surface of the radiation plate was brought into contact with a surface of a planar heater, as a heat-generating device requiring cooling. No component was provided on the opposite surface of the radiation plate to cool it naturally by outside air. The heater was supplied with an AC voltage of 90 V. According to measurement with a chromel-alumel thermocouple, the temperature of the junction between the heater and the radiation plate was 99°C.

Comparative Example 2

The same radiation plate as in Example 3 was prepared with its terminals not short-circuited, and was attached to a planar heater. The temperature measured under the same conditions as in Example 3 was 101°C.

Comparative Example 3

A 28-ohm resister was connected as an external load between the terminals of the same radiator plate as in Example 3. The temperature measured under the same conditions as in Example 3 was 101°C.

The results of Example 3 and Comparative Examples 2 and 3 show that the temperature, namely 101°C, could be reduced by about 2°C by changing the terminals from an open-circuit state to a short-circuit state, while no temperature change occurred when the resistor was connected as an external load.

Industrial Applicability

According to the present invention, a cooling effect can be achieved simply by attaching a cooling device composed of a single element such as a radiation plate to an electronic component requiring cooling. This cooling device requires no control circuit, has a simple structure, and is energy-saving because it can operate with no external power supply. The present invention can also provide either a p-type or n-type thermoelectric conversion element to have the significant effect of reducing production cost and operating cost.

**Claims**

1. A cooling device for an electronic component, comprising a thermoelectric conversion material (1) disposed between two electrodes (2,3) that function as a cathode and an anode and are electrically short-circuited, the cooling device being brought into contact with an electronic component requiring cooling so that one electrode side in contact with the thermoelectric conversion material becomes a low-temperature side and the other electrode side becomes a high-temperature side, a temperature difference between the two electrodes causing the thermoelectric conversion material to produce a thermoelectromotive force which generates current to cool the high-temperature side.

2. The cooling device for an electronic component according to Claim 1, wherein the thermoelectric conversion material (1) is either a p-type material or an n-type material or a combination of p-type and n-type materials arranged alternately in series.

3. A cooling system comprising two or more stacked cooling devices according to Claim 1.

4. A cooling system comprising the cooling device according to Claim 1.

**Patentansprüche**

1. Kühlvorrichtung für ein elektronisches Bauelement, umfassend ein thermoelektrisches Konversionsmaterial (1), das zwischen zwei Elektroden (2, 3), die als eine Kathode und als eine Anode fungieren und elektrisch kurzgeschlossen sind, angeordnet ist, wobei die Kühlvorrichtung in Kontakt mit einem elektronischen Bauelement, das einer Kühlung bedarf, gebracht ist, so dass eine Elektrodenseite, die sich in Kontakt mit dem thermoelektrischen Konversionsmaterial befindet, eine Niedertemperaturseite und die andere Elektrodenseite eine Hochtemperaturseite wird, wobei eine Temperaturdifferenz zwischen den beiden Elektroden das thermoelektrische Konversionsmaterial dazu veranlasst, eine thermoelektromotorische Kraft zu erzeugen, die Strom zum Kühlen der Hochtemperaturseite erzeugt.

2. Kühlvorrichtung für ein elektronisches Bauelement gemäß Anspruch 1, **dadurch gekennzeichnet, dass** das thermoelektrische Konversionsmaterial (1) entweder ein Material des p-Typs oder ein Material das n-Typs oder eine Kombination von Materialien des p-Typs und des n-Typs, die abwechselnd in Reihe geschaltet sind, ist.

3. Kühlsystem umfassend zwei oder mehr übereinander angeordnete Kühlvorrichtungen gemäß Anspruch 1.

4. Kühlsystem umfassend die Kühlvorrichtung gemäß Anspruch 1.

**Revendications**

1. Dispositif de refroidissement pour un composant électronique, comprenant un matériau de conversion thermoélectrique (1) disposé entre deux électrodes (2, 3) qui fonctionnent comme une cathode et une anode et sont électriquement court-circuitées, le dispositif de refroidissement étant amené en contact avec un composant électronique nécessitant un refroidissement de sorte qu'un côté électrode en contact avec le matériau de conversion thermoélectrique devient un côté basse température et l'autre côté électrode devient un côté haute température, une différence de température entre les deux électrodes amenant le matériau de conversion thermoélectrique à produire une force thermoélectromotrice qui génère du courant pour refroidir le côté haute température.

2. Dispositif de refroidissement pour un composant électronique selon la revendication 1, dans lequel le matériau de conversion thermoélectrique (1) est soit un matériau de type p, soit un matériau de type n, soit une combinaison de matériaux de type p et de type n disposés alternativement en série.

3. Système de refroidissement comprenant deux dispositifs de refroidissement empilés ou plus conformément à la revendication 1.

4. Système de refroidissement comprenant le dispositif de refroidissement conformément à la revendication 1.

# FIG.1

2 Electrode

1 Thermoelectric
Conversion
Material

4 Conductor

3 Electrode

# FIG.2

3 Electrode

2 Electrode

2

5 Insulating Substrate

2

1 Thermoelectric
Conversion
Material

| p | n | p | n | p | n |

4 Conductor

3

6 Insulating
Substrate

3

3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 9139525 A
- JP 2002050727 A
- JP 7015140 A
- JP 7202094 A

- JP 2710750 B
- JP 2001308395 A
- JP 2002151873 A